# EUROPEAN PATENT APPLICATION

(11) **EP 0 863 513 A2**
(43) Date of publication of application: **09.09.1998**
(21) Application number: 98103333.5
(22) Date of filing: 26.02.1998
(51) Int. Cl.: G11C 16/06

(54) **Method of writing data into memory with finite guaranteed write number of times and device for writing data into such memory**

(30) Priority: 05.03.1997 JP 65621/97
(71) Applicant: ZEXEL CORPORATION, Tokyo 150 (JP)
(72) Inventor: Kato, Kazuki, Zexel Higashi Matsuyama Plant, Saitama 355-8603 (JP)
(74) Representative: Patentanwälte Gesthuysen, von Rohr, Weidener, Häckel

(57) **Abstract**

Three memory addresses A, B, C are used as a set, and then their contents are divided into an access information area and an actual data area. Every time when data are to be written, a value obtained by adding 1 to the access information in the preceding memory address is written into the access information area and also desired data are written into the actual data area. Based on the access information in the access information area, one of three memory addresses A, B, C is designated circulatingly every data write.

## Description

### BACKGROUND OF THE INVENTION

### Field of the Invention:

The present invention relates to a method of writing data into a writable/erasable IC memory and, more particularly, a data writing method which enables an IC memory with finite guaranteed write number of times to increase the write number of times substantially beyond the guaranteed write number of times, a device for writing data into such memory, and a recording medium for recording a data writing program for such memory.

### Description of the Related Art:

As the IC memory which has the finite guaranteed value as the write number of times, there is a memory which is representative of the EEPROM (Electrically Erasable Programmable Read-Only Memory), for example.

More particularly, among the writable IC memories such as the EEPROM, there are such memories that have the guaranteed limit number of times within which data can be normally read. In such memories, data can be normally written thereinto if data write is executed in the predetermined access unit, for example, the byte unit, within the guaranteed limit number of times, but data cannot always be normally written thereinto if data write is executed in excess of the guaranteed limit number of times.

However, in practice, according to the situation that the device into which such IC memory is incorporated is employed, there are cases where the actual write number is likely to exceed the limit write number of times guaranteed by the IC maker as above, or the actual write number surely exceeds the limit write number of times. In such case, the quickest measure is that the IC memory with higher guaranteed limit number of times would be employed. However, since it is a matter of course that cost of the device is inevitably increased in such case, such quickest measure is not always reasonable. In addition, in the event that the actual data write number of times is close to the guaranteed limit number of times, it is not possible to say that such measure is a good policy with regard to its cost performance.

Nevertheless, a conclusive or decisive measure has not been implemented up to now even though the reasonable measure which does not bring the cost up and which can ensure reliability and safety of the IC memory in operation has been requested in such case.

### SUMMARY OF THE INVENTION

It is an object of the present invention to provide a method of writing data into a memory with a finite guaranteed write number of times, which enables an IC memory with finite guaranteed write number of times, representative to an EEPROM, to increase the write number of times substantially beyond the guaranteed write number of times by virtue of a simple approach, and a device for writing data into such memory.

It is another object of the present invention to provide a method of writing data into a memory with a finite guaranteed write number of times, which is capable of increasing the substantially writable number of times without newly providing a particular hardware in a device into which an IC memory is to be incorporated, and a device for writing data into such memory.

It is still another object of the present invention to provide a method of writing data in to a memory with a finite guaranteed write number of times, which is capable of increasing data writable number of times with good efficiency by use of a required minimum access memory amount, and a device for writing data into such memory.

In order to achieve the above objects of the present invention, according to a first aspect of the present invention, there is provided a method of writing data into a memory with a finite guaranteed write number of times, which enables the memory with the finite guaranteed write number of times to increase the write number of times substantially beyond the finite guaranteed write number of times, the method comprising the steps of:
selecting plural memory addresses, into which data are to be written, as one set respectively; and
shifting memory addresses circulatingly within the plural memory addresses as the one set, every time when data are written.

Accordingly, such method can decrease a frequency of writing data into one memory address by using plural memory addresses circulatingly, and the data can be written as a whole substantially beyond the guaranteed write number of times.

As the preferred embodiment of the present invention, a data format in respective memory address is divided in to an access information area into which a predetermined value is written according to predetermined procedures every time when data are written, and an actual data area into which real data per se are written, and
deciding a memory address as a data writing object based on access information in the access information area.

As the preferred embodiment of the present invention, the method of writing data into a memory with a finite guaranteed write number of times, further comprises the steps of:
when data write request is generated, adding 1 to access information in the access information area in the memory address into which data are written immediately before the data write request is generated;
deciding a memory address as a data write object based on predetermined translation procedures, using a value calculated by addition and a value in the access information area in other memory addresses as reference values; and
writing a value calculated by the addition into the access information area of the memory address.

As the preferred embodiment of the present invention, the predetermined translation procedures are made by use of a translation table in which correspondences between access information in respective memory addresses and access addresses are tabulated previously.

As the preferred embodiment of the present invention, the method of writing data in to a memory with a finite guaranteed write number of times, further comprises the steps of:
when data are to be written, reading content of the memory address into which the data are written immediately before writing to thus compare the content with new write data; and
writing data into the memory address only when both the content and the new write data do not coincide with each other.

In order to achieve the above objects of the present invention, according to a second aspect of the present invention, there is provided a data writing device for a memory with a finite guaranteed write number of times, which enables the memory with the finite guaranteed write number of times to increase the write number of times substantially beyond the finite guaranteed write number of times, the device comprising:
address deciding means for deciding memory address, to which data are to be written, such that plural predetermined memory addresses are circulatingly used every time when data write request is generated; and
writing means for writing data in to the memory address decided by the address deciding means.

Accordingly, such device is suitable for executing the method of writing data into a memory with a finite guaranteed write number of times according to the first aspect of the present invention. Most parts of the address deciding means and the writing means can be achieved by executing the software by the CPU, for example. In particular, the device according to the present invention can be accomplished by modifying the software applied to the existing data writing device made of the CPU.

As the preferred embodiment of the present invention, the address deciding means comprises,
access information managing means for writing access information in predetermined bit positions of predetermined number of memory addresses respectively in compliance with predetermined procedures, when data write request is generated; and
address information managing means for deciding memory addresses, into which data are to be written, in compliance with predetermined translation procedures while referring to the access information written by the access information managing means, when data write request is generated.

As the preferred embodiment of the present invention, the access information managing means adds 1 to access information in the memory address into which data are written immediately before the data write request is generated, and then writes a sum calculated by addition into the access in formation area of the memory address next to the memory address, and
the address information managing means decides a memory address, into which data are to be written, based on a translation table in which correspondences between access information in respective memory addresses and access addresses are tabulated previously.

As the preferred embodiment of the present invention, the data writing device for a memory with a finite guaranteed write number of times, further comprises write controlling means for reading data in memory address, into which data are to be written, immediately before the data are written by the writing means to thus compare read data with new write data, and then terminate data write by the writing means if both data coincide with each other.

### BRIEF DESCRIPTION OF THE DRAWINGS

FIG.1 is a flowchart illustrative of procedures of writing data in to an EEPROM by a data writing device according to a first embodiment of the present invention;
FIG.2 is a schematic circuit diagram showing a configuration of a data writing device according to the first embodiment of the present invention;
FIG.3 is a schematic view showing one byte data format according to the first embodiment of the present invention;
FIG.4 is a schematic view showing three access information areas for three addresses in an initial condition;
FIG.5 is a schematic view showing an example of a translation table used to decide access data based on access information;
FIG.6 is a schematic view showing states of access information when data write request is generated following to the state shown in FIG.5;
FIG.7 is a schematic view showing change of access information and access address; and
FIG.8 is a flowchart illustrative of pertinent procedures of writing data into the EEPROM by use of a data writing device according to a second embodiment of the present invention.

### DESCRIPTION OF THE PREFERRED EMBODIMENTS

Details of preferred embodiments of the present invention will be explained with reference to the accompanying drawings hereinafter

It is obvious for one skilled in the art that constituent members, parts, arrangements, etc. to be described hereinafter should be interpreted not to limit the present invention and therefore they nay be changed, modified, or varied without departing a scope of the present invention.

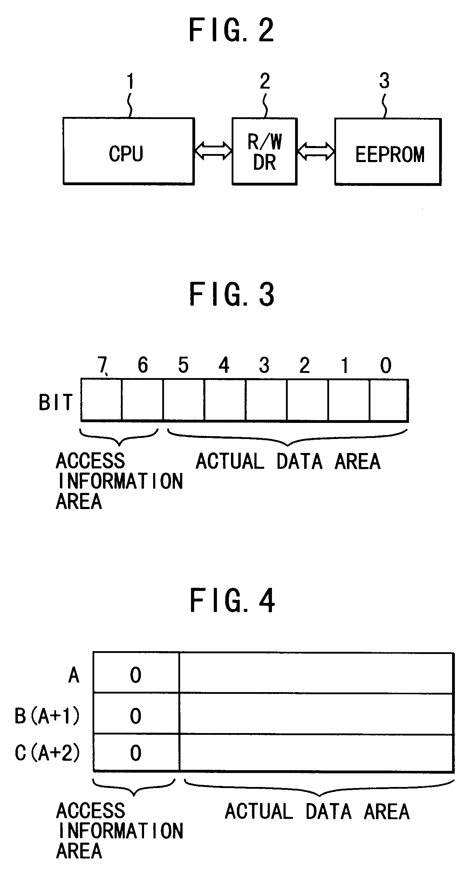

At first, a configuration of a data writing device (referred to as a "present device" hereinafter) by which a method of writing data into a memory with finite guaranteed write number of times according to embodiments of the present invention is executed will be explained hereunder. The present device comprises a CPU 1, and a read/write driver (labeled as "R/W DR" in FIG.2) 2, and thus is constructed such that data can be written into an EEPROM 3 and also data can be read from the EEPROM 3 (see FIG.2).

The CPU 1 is made up of a so-called one-chip microcomputer. For example, the CPU 1 can read/write data from/into the EEPROM 3 via the read/write driver 2 by executing the program stored previously therein.

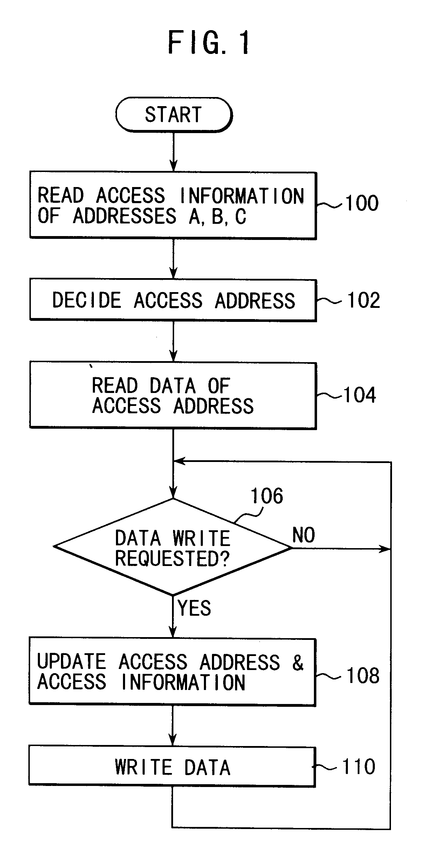

Subsequently, the method of writing data into the EEPROM 3 in such configuration will be explained with reference to FIGS.1 to 8 hereunder.

First of all, the method of writing data into the memory with the finite guaranteed write number of times (referred to as a "present method" hereinafter) in the embodiments of the present invention will be explained in brief, and then it will be concretely explained.

The present method can be summarized as that, under the assumption that, for example, writing of data into the IC memory is carried out in the unit of byte, a frequency of writing data in to one address can be reduced by selecting an address as the write object from a set of plural bytes sequentially every time when data are written as the set of plural bytes and as a result the guaranteed write number of times of the IC memory can be increased substantially.

Next, the method of writing data into the EEPROM 3 will be explained in detail hereunder.

When the method of writing data is carried out by the CPU 1, first of all access information in a plurality of previously set addresses of the EEPROM 3 are read (see step 100 in FIG.1).

More particularly, in the first embodiment of the present invention, three addresses, e.g., addresses A, B (B=A+1), C (C=A+2) are selected as a set to execute data write. Then, one of the three addresses A, B, C is sequentially selected to be written every time when data are written. For example, if an individual address. i.e., one byte address is made up of eight bits as shown in FIG.3, upper two bits and lower six bits in a data format are allocated as an access information area and an actual data area respectively. Information serving as a reference used to decide the address as the data read/write object, i.e., access object is stored in to the access information area (details will be described), and data per se which are handled actually with is stored in to the actual data area.

In step 100, access information in three addresses A, B, C are read respectively.

Then, based on access information in three addresses A, B, C which have been read as above, the access address can be decided in compliance with predetermined approach which has been previously set (see step 102 in FIG.1).

More particularly, for the first time, i.e., in a state that all data are set to zero because of the initialization of the EEPROM 3, information stored in the access information area, i.e., all access information in the addresses A, B, C are set to zero (see FIG.4). It is scheduled beforehand that, if three access information are entirely zero, the address A would be decided as the access address. Therefore, if step 102 is under such situation, the address A is decided as the access address.

As the above predetermined approach to decide the access address from the access information, a so-called two-dimensional translation table is preferable, for example.

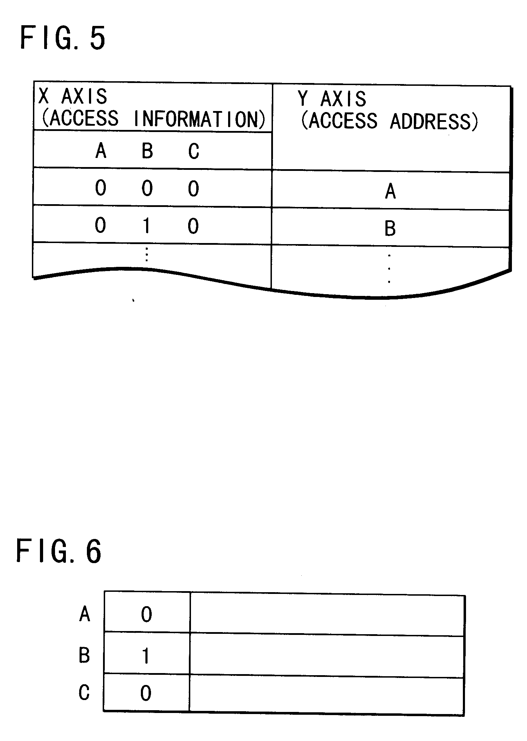

In FIG.5, an example of such two-dimensional translation table is shown. The two-dimensional translation table will be explained with reference to FIG.5 hereinbelow. The translation table is formed by tabulating the access information in respective addresses and corresponding access address. As described later, the access information are set such that such access information in the access address corresponding to the memory area, into which next data are written, are rewritten sequentially every time when data are to be written. Therefore, since particular correspondences be established between states of the access information in three addresses and the access addresses respectively, the translation table shown in FIG.5 can be formed by examining such particular correspondences previously and then tabulating them. In essence the access information consist of two-bit binary digits, but, for convenience of easy understanding of this disclosure, the access information are given by decimal digits in the translation table shown in FIG.5.

Then, reading of data from the address decided as above is executed (see step 104 in FIG.1). If reading of data is not needed, process in step 104 may be omitted and thus the process may advance to next step 106 immediately.

Then, it is decided whether or not data write request is generated (see step 106 in FIG.1).

If the user decides the presence of such data write request every input address via predetermined key input using a keyboard (not shown) connected to the CPU 1, for example, such decision that the data write request is generated or not may be executed by determining whether or not a predetermined key is depressed. Alternatively, in the event that both the addresses which require data write and the data are input previously into a predetermined memory area of the CPU 1, data write may be carried out automatically by reading the address and the data. In such case, the presence of the data write request in step 106 may be decided by determining whether or not the data used to write such data are loaded into the predetermined memory area.

If it has been decided that the data write request is needed (if "YES" in step 106), the access information can be updated, then the access address can be decided based on such updated access information, and then the access address can be output to the read/ write driver 2 to thus update such access address (see step 108 in FIG.1).

More particularly, if, as described above with reference to FIG.4, respective access information at the point of time when the data write request is generated are all zero, for example, the access information in the address B can be updated from "0" to "1" in the update process of the access information (see FIG.6). Although the actual access information consist of the binary digits, the decimal digits are employed in the description of the embodiment of the present invention for convenience of easy understanding.

Then, with reference to the translation table (see FIG.5) described above, the access address can be decided based on the updated access in formation. In this case, the access address is set to "B".

Then, this access address can be output to the read/write driver 2 in order to update the access address in the read/write driver 2.

In turn, writing of data in to the memory area having the updated access address is effected by the read/write driver 2 (see step 110 in FIG.1). After this, the process returns to step 106 once again to be put into a state to wait the data write request (see step 106 in FIG.1).

Subsequently, as described above, the access information can be updated every time when the write request is generated, then the access address can be decided based on the updated access information, and then data can be written into the memory area having the concerned access address (see step 110 in FIG.1).

Accordingly, three addresses can be used circulatingly such that the address of the memory area into which data are to be written are set sequentially in order of "A"→"B"→"C" every data write and then the "A" address is set again subsequently to the "C" address.

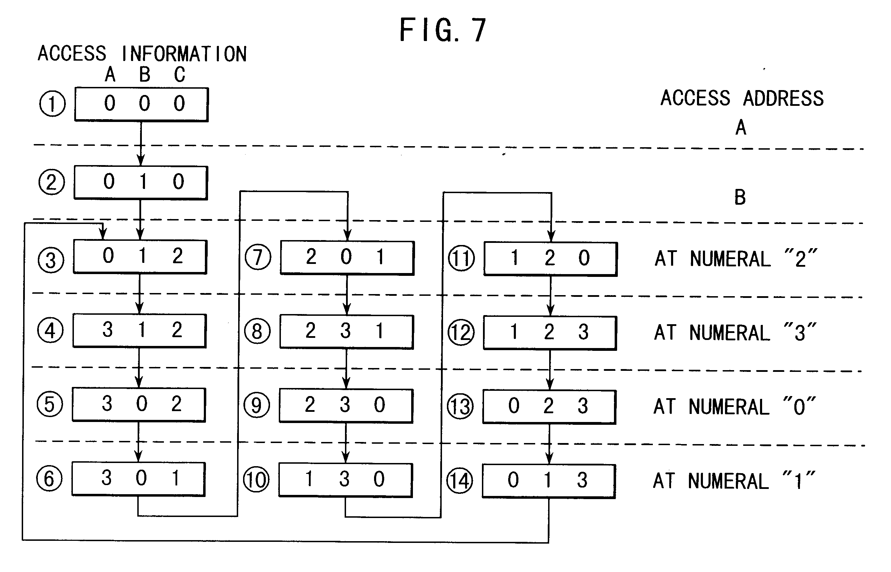

In the situation that three addresses are used circulatingly in this fashion, change of the access information and change of corresponding access address are shown schematically in FIG.7. As described previously, in an initial state, all access information are zero and therefore the access addresses are set to "A" (see portion labeled as "1 enclosed with a circle" in FIG.7). Then, when the data write request is generated, the access information in "B" is set to "1" and the access address is set to "B" (see portion labeled as "2 enclosed with a circle" in FIG.7). Next, in response to the data write request, the access in formation in "C" is set to "access information in B + 1", i.e., 1+1=2 and also the access address is set to "C" (see portion labeled as "3 enclosed with a circle" in FIG. 7). Thereafter, if the data write request is newly generated, the access information in "A" is set to "access information in C + 1", i.e., 2+1=3 and also the access address is set to "A" (see portion labeled as "4 enclosed with a circle" in FIG.7). In addition, if next data write request is newly generated, the access information in "B" is set to "access in formation in A + 1", i.e., it becomes zero again because of addition of two-bit binary digits and also the access address is set to "B" (see portion labeled as "5 enclosed with a circle" in FIG.7). In the following, respective states labeled as "3 enclosed with a circle" to "14 enclosed with a circle" in FIG.7 are repeated circulatingly in the same manner.

Consequently, assume that the guaranteed write number of times of the above addresses A, B, C is a hundred thousand, for example, if the above method of writing data into the memory of the present invention is applied, the write number of times per address, i.e., per byte can be increased up to three hundred thousands as a whole. As a result, substantially the guaranteed write number of times can be increased.

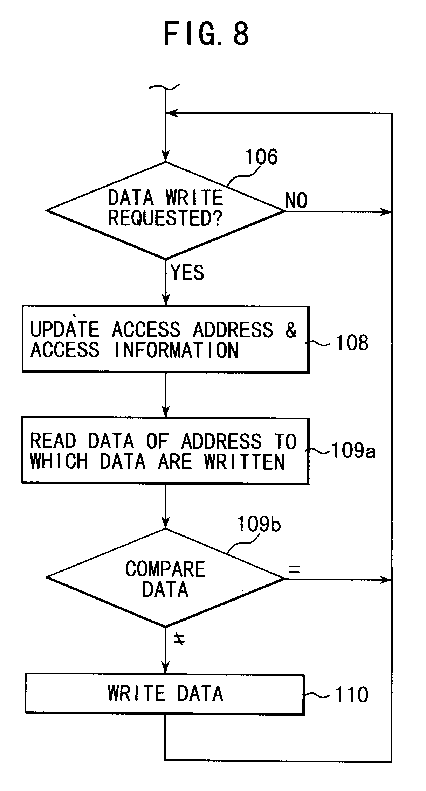

Next, pertinent procedures of writing data into the EEPROM by a data writing device according to a second embodiment of the present invention will be explained with reference to FIG.8 hereunder.

In the second embodiment, steps of deciding whether or not the data to be written is the sane as the data in the write destination and then omitting data write if both data are equal are supplemented between step 108 and step 110 in the above first embodiment.

In other words, as shown in FIG.8, after the process in step 108 has been executed, the data in the actual data area of the memory address, into which data are to be written, are read (see step 109a in FIG.8) and then such data is compared with data to be newly written (see step 109b in FIG.8). Then, if both data are the same data, the process returns to step 106 without execution of the process in step 110. In contrast, only when both data are different data, the process in step 110 is executed. In FIG.8, since not-shown procedures are similar to those shown in FIG.1, their redundant detailed description is omitted herein.

In order to facilitate understanding of the present invention, the unit of data write has been assumed as one byte in the above embodiments. However, it is of course that the unit of data write is not limited to one byte, and plural bytes may be applied in the same way even if they are used as the unit of data write. In addition, one byte does not always consist of eight bits and of course other bit number may be employed. Moreover, the one-byte data format is not always partitioned such that the access information area is two bits and the actual data area is six bits, as shown in FIG.3. With regard to the bit number in one byte and the number of memory addresses in which data write is executed circulatingly, this data format may be set appropriately. Further, arrangement of the access information area and the actual data area in one byte is not limited to the arrangement shown in FIG. 3. For instance, the lower two bits may be set as the access information area and the upper six bits may be set as the actual data area.

Besides, in the above embodiments, the read/write driver 2 have been explained to have both the function of reading the data from the EEPROM 3 and the function of writing the data into the EEPROM 3. However, the read/write driver 2 may have only the function of writing the data into the EEPROM 3.

Furthermore, although the explanation has been made under the assumption that the programs used to execute data write shown in the flowcharts in FIGS.1 and 8 are stored in the CPU 1, such programs are not always stored in the CPU 1. For example, such programs may be stored in various memory means (floppy disk, magnetic disk, magnetic tape, etc.) and then, upon execution, they may be read from various memory means to the CPU 1. In this case, it is of course that readers suitable for respective memory means (for example, floppy disk drive, etc.) are needed.

In the above embodiments, the access information managing means can be achieved by executing steps 106, 108 (see FIG.1) by the CPU 1, the address information managing means can be achieved by executing steps 100, 102, 108 (see FIG.1) by the CPU 1, the writing means can be achieved by executing step 110 (see FIG.1) by the CPU 1 and the read/write driver 2, and the write controlling means can be achieved by executing steps 109a, 109b (see FIG.8) by the CPU 1.

As explained as above, according to the present invention, since a plurality of memory addresses are used circulatingly, the data write number of times can be increased substantially beyond the guaranteed write number of times. In particular, because a part of the contents of the memory is employed to store information necessary to use the memory addresses circulatingly and remaining part of the contents of the memory is employed as the actual data storing area, effective use of the memory can be attained and also, while using the required minimum access memory amount, the data write number of times can be increased substantially beyond the guaranteed write number of times.

In addition, the present invention can be accomplished by modifying only the so-called software in the existing data writing device, without supplement of new hardware. Therefore, the device with extremely high practicality can be provided at low cost.

## Claims

1. A method of writing data into a memory with a finite guaranteed write number of times, which enables the memory with the finite guaranteed write number of times to increase the write number of times substantially beyond the finite guaranteed write number of times, the method comprising the steps of:
selecting plural memory addresses, into which data are to be written, as one set respectively; and
shifting memory addresses circulatingly within the plural memory addresses as the one set, every time when data are written.

2. A method of writing data into a memory with a finite guaranteed write number of times, according to claim 1, further comprising the steps of dividing a data format in respective memory address is divided in to an access information area into which a predetermined value is written according to predetermined procedures every time when data are written, and an actual data area in to which real data per se are written, and
deciding a memory address as a data writing object based on access information in the access information area.

3. A method of writing data into a memory with a finite guaranteed write number of times, according to claim 2, further comprising the steps of:
when data write request is generated, adding 1 to access information in the access information area in the memory address into which data are written immediately before the data write request is generated;
deciding a memory address as a data write object based on predetermined translation procedures, using a value calculated by addition and a value in the access information area in other memory addresses as reference values; and
writing a value calculated by the addition into the access information area of the memory address.

4. A method of writing data into a memory with a finite guaranteed write number of times, according to claim 3, where in the predetermined translation procedures are made by use of a translation table in which correspondences between access information in respective memory addresses and access addresses are tabulated previously.

5. A method of writing data into a memory with a finite guaranteed write number of times, according to any preceding claim, further comprising the steps of:
when data are to be written, reading content of the memory address into which the data are written immediately before writing to thus compare the content with new write data; and
writing data into the memory address only when both the content and the new write data do not coincide with each other.

6. A data writing device for a memory with a finite guaranteed write number of times, which enables the memory with the finite guaranteed write number of times to increase the write number of times substantially beyond the finite guaranteed write number of times, the device comprising:
address deciding means for deciding memory address, to which data are to be written, such that plural predetermined memory addresses are circulatingly used every time when data write request is generated; and
writing means for writing data into the memory address decided by the address deciding means.

7. A data writing device for a memory with a finite guaranteed write number of times, according to claim 6, wherein the address deciding means comprises,
access information managing means for writing access information in predetermined bit positions of predetermined number of memory addresses respectively in compliance with predetermined procedures, when data write request is generated; and
address information managing means for deciding memory addresses, into which data are to be written, in compliance with predetermined translation procedures while referring to the access in format ion written by the access information managing means, when data write request is generated.

8. A data writing device for a memory with a finite guaranteed write number of times, according to claim 7, where in the access information managing means adds 1 to access information in the memory address in to which data are written immediately before the data write request is generated, and then writes a sum calculated by addition into the access information area of the memory address next to the memory address, and
the address information managing means decides a memory address, into which data are to be written, based on a translation table in which correspondences between access information in respective memory addresses and access addresses are tabulated previously.

9. A data writing device for a memory with a finite guaranteed write number of times, according to claim 6, claim 7, or claim 8, further comprising write controlling means for reading data in memory address, into which data are to be written, immediately before the data are written by the writing means to thus compare read data with new write data, and then terminate data write by the writing means if both data coincide with each other.
